# EUROPEAN PATENT APPLICATION

(11) **EP 2 330 751 A1**
(43) Date of publication of application: **08.06.2011**
(21) Application number: 09178169.0
(22) Date of filing: 07.12.2009
(51) Int. Cl.: H04B 1/38, H05K 5/00

(54) **Shielding case for mobile or radio telephone**

(71) Applicant: StealthMan SC, 5300 Gabrovo (BG)
(72) Inventor: Lessev, Ivan, 5300, Gabrovo (BG)
(74) Representative: Benatov, Emil Gabriel

(57) **Abstract**

The shielding case is applied in mobile communications. It attenuates the absorbed radiofrequency radiation, and does not interrupt the functioning of the phone. The case comprises a layer (1) with flexible layers - screening transaudient (1.1) and reflecting transaudient (1.2) layers located at the front wall (4) of the case between the outer (2) and the inner (3) soft layers with apertures over the earpiece (5) and the mouthpiece (6). The layers (2, 3) are glued to the layer (1) using electroconductive glue (8). The front wall (4) of the case is flexible. The green and red call buttons (11, 12) of the phone (9) are marked on the flexible front wall (4) of the shielding case. The layers (1, 2, 3) cover the side walls and the wall with the antenna (10). The back wall comprises the layers (2, 3) glued together using nonconductive glue (13). The wall opposite to the antenna (10) is an aperture (7) for getting the phone in and out of the case. The layer (1) can be a homogenous flexible composition of nonmetal electroconductive compounds and metals.

## Description

### FIELD OF APPLICATION

The shielding case for mobile or radio telephone is applied in mobile communications.

### PREVIOUS STATE OF ART

It is known a shielding case for mobile or radio telephone that consist of a laminate material comprising an outer protective layer, a soft inner layer and a central layer of a flexible metal-coated mesh or woven fabric. The central layer causes high attenuation of the radiation from at least the areas of the device in close proximity to the user. The case may also incorporate a vertical tongue to form a screen and attenuate radiation from the aerial to the user. The case has elastic bands sewed to its front wall for fixing on the MT [GB230726].

The disadvantage of this shielding case is that the screening layer which protects the user of the mobile or radio telephone - T from harmful emissions, partially absorbs the emission from the phone(T)'s antenna thus forcing the mobile telephone to increase its emission power automatically. This leads to fast phone battery exhaustion requiring more frequent charging of the battery, decreasing the time of calls after one charging, and decreasing the time during which the phone works in standby mode.

### TECHNICAL ESSENCE OF THE INVENTION

The aim of the invention is to provide a highly effective shielding case for mobile or radio telephone which repeatedly attenuates the radiofrequency radiation absorbed by human soft tissues, no matter whether the mobile cell signal is strong or weak. Moreover:
- the shielding case must not prevent the phone from connecting to the cell;
- the shielding case must not increase the emission power when using the phone, thus keeping the time of call after one battery charging unchanged;
- the shielding case must not affect the time during which the phone works in standby mode.

This aim is attained by providing a shielding case for mobile or radio telephone comprising a protective layer of flexible screening transaundient layer located at the front wall of the case between outer layer and inner layer of soft material. The outer and the inner layers have apertures in the earpiece and mouthpiece areas of the phone. The flexible screening transaudient layer reflects radio waves via a second flexible screening transaudient layer. The outer and the inner layer are glued to the flexible screening-reflecting transaudient layer using electroconductive glue. The front side of the case is flexible. The green and red call buttons of the phone are marked on the flexible front side of the shielding case. The shielding case is pocket type, and the three layers cover the side walls and the wall with the antenna of the phone while the back wall, which is opposite to the front wall of the case, comprises only the outer and the inner layers glued together using non-conductive glue. The side which is opposite to the antenna of the phone is an aperture for getting the phone in and out of the shielding case.

In this shielding case for mobile and radio telephone, said flexible screening-reflecting transaudient layer may comprise protective screening layer and reflecting layer glued together using electroconductive glue.

The flexible screening-reflecting transaudient layer of the shielding case for mobile and radio telephone can comprise a homogeneous flexible nonmetal composition, electroconductive nonmetal compounds and/or metals, while the composition layer consists of metal sulfides and/or metal oxides, and/or graphite particles and metals [RU2102801]. In this variant, the flexible screening-reflecting transaudient layer is glued to the outer layer using flexible electroconductive glue. On the other hand, the flexible screening-reflecting transaudient layer is glued to the inner layer using flexible nonconductive glue.

The shielding case for mobile and radio telephone can be "cigarette box" type containing an opening front wall with a flexible hinge and a fixing pocket for the phone.

The advantage of the shielding case for mobile or radio telephone is that it has high effectiveness because it greatly attenuates the radiofrequency radiation absorbed by human soft tissues. It does not prevent the phone from connecting to the cell, it does not increase the emission power when using the phone, thus keeping the time of call after one battery charging unchanged, and it does not affect the time during which the phone works in standby mode, no matter whether the mobile cell signal is strong or weak.

### DESCRIPTION OF ACCOMPANYING FIGURES

The invention is explained in more details in the accompanying figures, where:
- Fig. 1 is a longitudinal section of a "pocket" type shielding case with a flexible double layer screening-reflecting layer;
- Fig. 2 is a longitudinal section of a "pocket" type shielding case with a flexible screening-reflecting layer - homogenous flexible composition;
- Fig. 3 is a longitudinal section of an opening "cigarette box" type shielding case with top location of the phone antenna;
- Fig. 4 is a longitudinal section of an opening "cigarette box" type shielding case with bottom location of the phone antenna;

### PREFERRED EMBODIMENT AND FUNCTIONING OF THE INVENTION

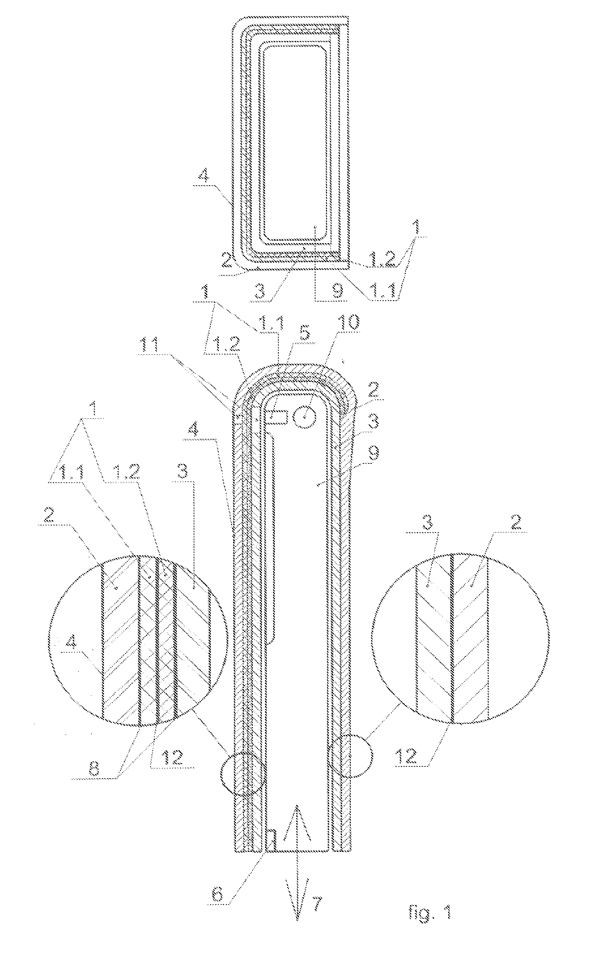

The shielding case for mobile or radio telephone 9 (Fig.1) comprises a protective layer 1 of flexible screening transaudient layer 1.1 located at the front wall 4 of the case between outer layer 2 and inner layer 3 of soft material. The outer layer 2 and the inner layer 3 have apertures in the earpiece 5 and mouthpiece 6 areas of the phone 9. The flexible screening transaudient layer 1 reflects radio waves via a second flexible screening transaudient layer 1.2. The outer layer 2 and the inner layer 3 are glued to the flexible screening-reflecting transaudient layer 1 using electroconductive glue 8. The front wall 4 of the case is flexible. The green 11 and red 12 call buttons of the phone 9 are marked on the flexible front wall 4 of the shielding case. The shielding case is "pocket" type, and the three layers 1, 2, 3 cover the side walls and the wall with the antenna 10 of the phone 9 while the back wall, which is opposite to the front wall of the case, comprises only the outer 2 and the inner 3 layer glued together using nonconductive glue 13. The side which is opposite to the antenna 10 of the phone 9 is an aperture 7 for getting the phone 9 in and out of the shielding case.

As claimed in Claim 1, the flexible screening-reflecting transaudient layer 1 of the shielding case for mobile and radio telephone 9 (Fig. 1) can comprise protective screening layer 1.1 and reflecting layer 1.2 glued together using electroconductive glue 8.

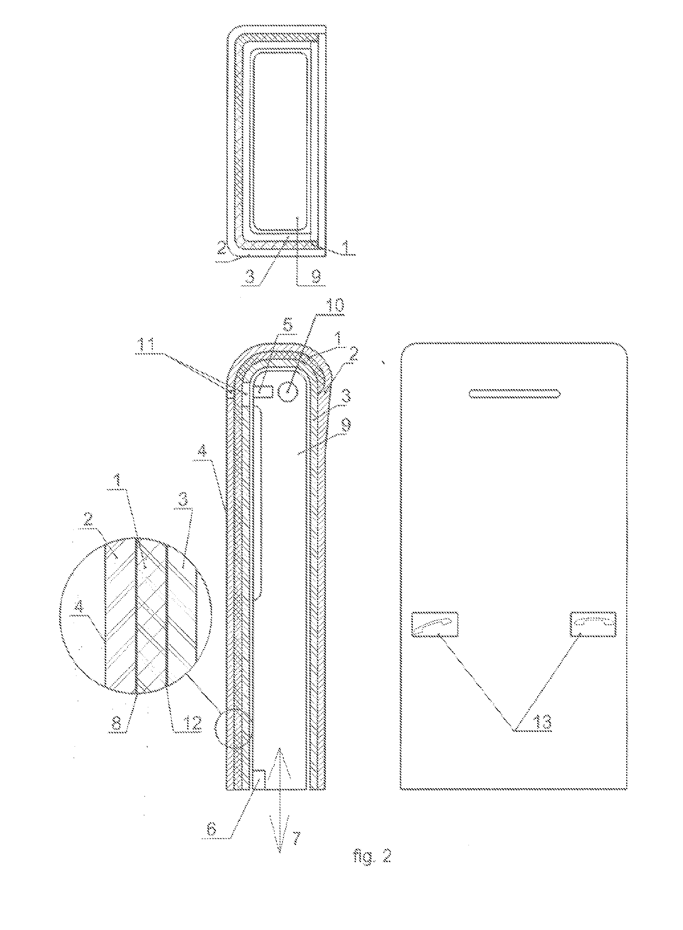

The flexible screening-reflecting transaudient layer 1 of the shielding case for mobile and radio telephone (Fig. 2) can comprise a homogeneous flexible nonmetal composition, electroconductive nonmetal compounds and/or metals, while the composition layer consists of metal sulfides and/or metal oxides, and/or graphite particles and metals [RU2102801]. In this variant, the flexible screening-reflecting transaudient layer 1 is glued to the outer layer 2 using flexible electroconductive glue 8. On the other hand, the flexible screening-reflecting transaudient layer 1 is glued to the inner layer 3 using flexible nonconductive glue 13.

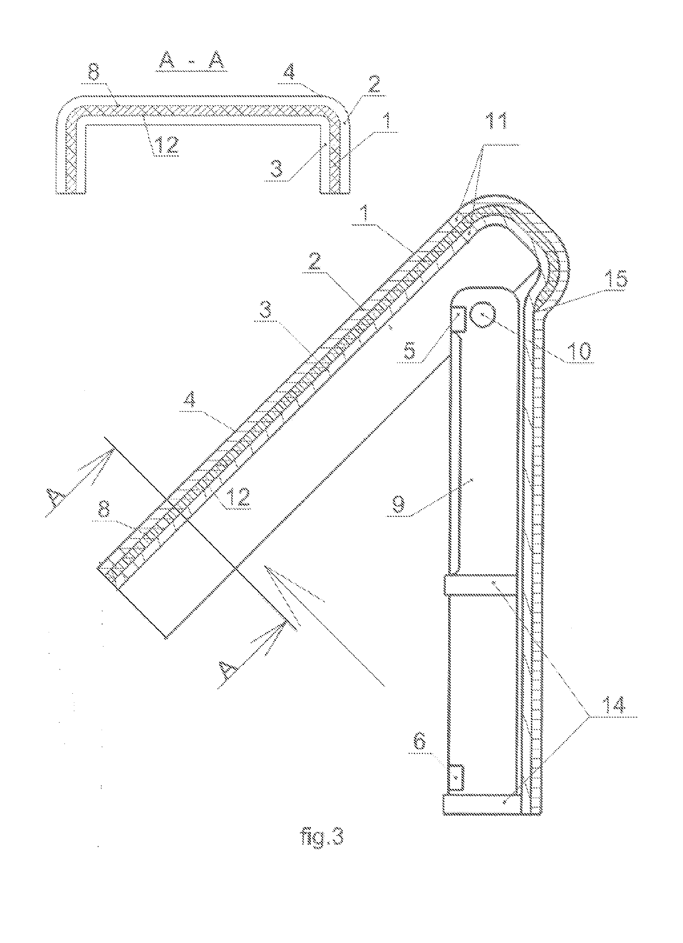

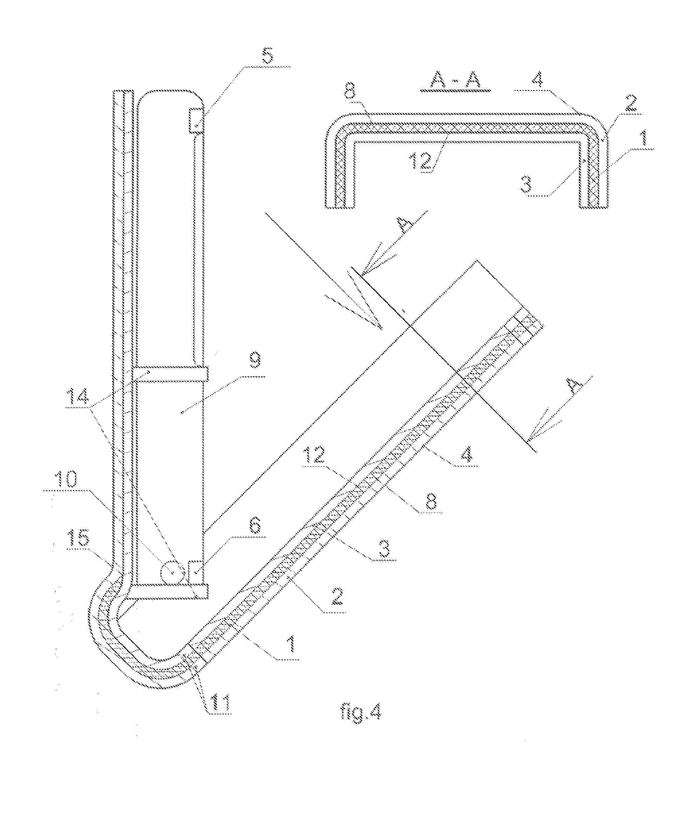

The shielding case for mobile and radio telephone can be "cigarette box" type (Fig. 3 and Fig. 4) containing an opening front wall 4 with a flexible hinge 15 and a fixing pocket 14 for the phone 9.

The flexible screening transaudient layer 1.1 serves to protect the user attenuating the specific absorption rate (SAR) of the soft tissues of human head and body by over 90% (more than 10 times) compared to the SAR value defined in the technical specifications of the manufacturer of the given mobile or radio telephone model. The flexible reflecting transaudient layer 1.2 reflects the radio frequencies in broad range by over 95% and serves to reflect the radio waves in the direction opposite to the head of the user of the phone 9. This way, it does not prevent the phone 9 from connecting to the cell, it does not increase the emission power when using the phone 9 with the shielding case, it keeps the time of call after one battery charging unchanged compared to the functioning of the phone 9 without shielding case. It also keeps the time during which the phone works in standby mode without shielding case unchanged. All these conditions are met no matter whether the mobile cell signal is strong or weak.

The flexible screening layer 1.1 and the flexible reflecting layer 1.2 are transaudient in order to ensure audibility without destroying their integrity in the earpiece 5 and mouthpiece 6 areas of the phone 9.

The usage of flexible electroconductive glue 8 increases the life time of the shielding case without worsening its initial performance characteristics and not allowing the electrical resistance of the screening and reflecting layer to increase due to their repeated flexion in the process of exploitation.

Since the front wall 4 of the shielding case is flexible, the user can accept or reject calls without getting the phone 9 out of the shielding case by pressing the spot 11 over the green call button of the phone 9 or the spot 12 over the red call button of the phone 9. When the shielding case is "pocket" type, the aperture 7 serves for getting the phone 9 in and out of the shielding case.

When the flexible screening-reflecting transaudient layer 1 is a homogenous composition [RU2102801], high protective characteristics from electric and electromagnetic fields and reflecting ability of more than 95% of the radio waves are achieved, together with increasing the life time of the shielding case.

The "pocket" type shielding case is widely applied for various brands and models of mobile phones 9. The internal dimensions of this shielding case do not allow any looseness between the case and the phone 9, therefore the phone cannot spontaneously fall out of the case. The shielding cases are designed individually for any given phone model. After getting the phone 9 out of the case, the user can view the display and operate the phone, when necessary. The "pocket" type shielding case cannot be used with slide or flip phone types.

The "cigarette box" type shielding case for mobile phones with an opening front wall 4 (Fig. 3 and Fig. 4) is primarily used for smartphones, iphones, iPods, etc. After opening the case via the flexible hinge 15, the user can freely operate the phone 9 without getting it out of the case. The flexible hinge 15 can be a separate element or the material which the front wall of the case is made of can be folded. After establishing the connection, the user can close the cover of the case and carry on the conversation. The "cigarette box" type shielding cases are also designed individually for any given phone model. The phone 9 is fixed in the "cigarette box" type shielding case via the fixing pocket 14 designed according to the model of the phone 9. Both variants of the "cigarette box" type shielding case are consistent with the location of the phone's antenna 10 - top and bottom.

The shielding case can have certain additions for attachment to the belt, hanging on the neck, etc. They do not change nor worsen the performance of the shielding case for mobile and radio telephones 9. For that reason, they are not shown in the figures.

## Claims

1. A shielding case for mobile or radio telephone comprising a protective layer 1 of flexible screening transaudient layer (1.1) which is located at the front wall (4) of the case between outer 2 and inner 3 layer of soft material. The outer and the inner layer (2 and 3) have apertures in the earpiece (5) and mouthpiece (6) areas of the phone (9), **characterized in that** the flexible screening transaudient layer (1) also reflects radio waves via a second flexible screening transaudient layer (1.2), while the outer layer (2) and the inner layer (3) are glued to the flexible screening-reflecting transaudient layer (1) using electroconductive glue (8). The front wall (4) of the case is flexible. The green (11) and red (12) call buttons of the phone (9) are marked on the flexible front wall (4) of the shielding case. The shielding case is "pocket" type, and the three layers (1, 2 and 3) cover the side walls and the wall with the antenna (10) of the phone (9) while the back wall, which is opposite to the front wall of the case, comprises only the outer and the inner layers (2 and 3) glued together using nonconductive glue (13). The side which is opposite to the antenna (10) of the phone (9) is an aperture (7) for getting the phone (9) in and out of the shielding case.

2. A shielding case for mobile or radio telephone, according to Claim 1, **characterized in that** the flexible screening-reflecting transaudient layer (1) comprises a protective screening layer (1.1) and a reflecting layer (1.2) glued together using electroconductive glue (8).

3. A shielding case for mobile or radio telephone, according to Claim 1, **characterized in that** the flexible screening-reflecting transaudient layer (1) is a homogeneous flexible nonmetal composition, electroconductive nonmetal compounds and/or metals, while the composition layer consists of metal sulfides and/or metal oxides, and/or graphite particles and metals. The flexible screening-reflecting transaudient layer (1) is glued to the outer layer (2) using flexible electroconductive glue (8). On the other hand, the flexible screening-reflecting transaudient layer (1) is glued to the inner layer (3) using flexible nonconductive glue (13).

4. A shielding case for mobile or radio telephone, according to Claim 1, **characterized in that** it is a "cigarette box" type with an opening front wall (4), a flexible hinge (15), and a fixing pocket (14) for the phone (9).
